(19) Europäisches Patentamt
European Patent Office
Office européen des brevets

(11) **EP 2 888 559 B1**

(12) **EUROPÄISCHE PATENTSCHRIFT**

(45) Veröffentlichungstag und Bekanntmachung des Hinweises auf die Patenterteilung:
**20.12.2017 Patentblatt 2017/51**

(21) Anmeldenummer: **13753842.7**

(22) Anmeldetag: **19.08.2013**

(51) Int Cl.:
*G01D 5/14* (2006.01)   *G01R 33/07* (2006.01)

(86) Internationale Anmeldenummer:
**PCT/EP2013/067225**

(87) Internationale Veröffentlichungsnummer:
**WO 2014/029727 (27.02.2014 Gazette 2014/09)**

(54) **SENSORANORDNUNG ZUR ERFASSUNG VON DREHWINKELN AN EINEM DREHBEWEGTEN BAUTEIL**

SENSOR ARRANGEMENT FOR DETECTING ANGLES OF ROTATION ON A ROTATED COMPONENT

ENSEMBLE CAPTEUR POUR DÉTECTER DES ANGLES DE ROTATION SUR UN ÉLÉMENT MIS EN ROTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.08.2012 DE 102012214916**

(43) Veröffentlichungstag der Anmeldung:
**01.07.2015 Patentblatt 2015/27**

(73) Patentinhaber: **Robert Bosch GmbH**
**70442 Stuttgart (DE)**

(72) Erfinder:
• **MAITERTH, Eduard**
**74074 Heilbronn (DE)**
• **KIMMERLE, Mathias**
**71711 Steinheim (DE)**
• **WALTER, Klaus**
**74321 Bietigheim-Bissingen (DE)**
• **KISSNER, Juergen**
**71570 Oppenweiler (DE)**
• **SIEDENTOPF, Joerg**
**74199 Untergruppenbach (DE)**

(56) Entgegenhaltungen:
EP-A1- 1 229 335       EP-A1- 1 406 068
EP-A2- 2 330 389       DE-A1-102012 100 194
JP-A- 2011 226 912     US-A1- 2011 175 600

**Beschreibung**

Stand der Technik

Die Erfindung geht aus von einer Sensoranordnung zur Erfassung von Drehwinkeln an einem drehbewegten Bauteil nach der Gattung des unabhängigen Patentanspruchs 1.

Zur Winkelerfassung einer drehenden Welle ist es aus dem Stand der Technik bekannt, die Drehbewegung eines Magneten zentrisch auf der Welle zu erfassen. Dazu wird die Drehung des Magnetvektors um die Drehachse mit entsprechend sensitiven Magnetsensoren, wie beispielsweise AMR- und/oder GMR-Sensoren, Hallsensoren, Hallsensoren mit integrierten Magnetfeldkonzentratoren usw. erfasst. Für das eingesetzte Sensorelement ist die Erfassung des rotierenden Magnetvektors wesentlich. Bei einem beispielsweise als Rundmagnet ausgeführten Magneten, welcher sich vor dem Sensorelement dreht, dreht sich auch der Magnetvektor. Diese Drehbewegung wird durch ein davor stehendes Sensorelement erfasst, welches Teil eines ASICs (Anwendungsspezifischer integrierter Schaltkreis) ist und den zur Magnetoberfläche parallelen Magnetvektor detektiert. Dies erfolgt bei einem zweidimensionalen oder dreidimensionalen Hallsensor durch eine indirekte Winkelerfassung über eine Arcus-Tangens-Funktion der gerichteten magnetischen Flussdichten. Ein solcher Hallsensor kann die Winkelposition des Rundmagneten über 360° eindeutig detektieren. AMR-Sensoren ermöglichen eine direkte Winkelerfassung und erfassen prinzipbedingt den Winkel des Magnetvektors direkt. Vorrichtungen zur Winkel- bzw. Wegerfassung können in Fahrzeugen in verschiedenen Betätigungseinrichtungen für Fahrzeugbremssysteme, zur Leuchtweitenregulierung, zur Winkelpositionserfassung von Wellen eingesetzt werden, insbesondere aber auch für eine Fahrerbremswunscherfassung am Bremspedal bzw. eine Fahrerbeschleunigungswunscherfassung am Gaspedal.

Die Messelemente sind auf einen definierten Winkelbereich ausgelegt. So kann beispielsweise ein AMR-Sensor typisch eine Winkeldrehung des Magnetvektors um 180° eindeutig erfassen. Zweidimensionale oder dreidimensionale Hallsensoren erfassen dagegen mittels integrierter Magnetfeldkonzentratoren oder durch Hallelemente in allen drei Ebenen eine Winkeldrehung des Magnetvektors um 360°. Die sich ergebenden Genauigkeiten sind auf diese Winkelbereiche optimal angepasst. Bei der Erfassung von Winkeln, die deutlich kleiner sind als der Messbereich des Sensorelements, reduziert sich die resultierende Auflösung respektive die Genauigkeit des Ausgangssignals bezogen auf den Messbereich. Bei einem Magnetwinkel ausweisenden Sensor, der einen Messbereich von 360° aufweist, reduziert sich die prozentuale Genauigkeit bezogen auf den Messbereich um einen Faktor 10, wenn der gesamte Messbereich in der Applikation lediglich 36° betrifft.

In der DE 10 2009 055 104 A1 wird eine Magnetfeldsensoranordnung zur Wegerfassung an translatorisch beweglichen Bauteilen beschrieben. Bei der beschriebenen Magnetfeldsensoranordnung ändern sich räumliche Komponenten des magnetischen Feldes eines Magnetsystems am bewegten Bauteil in ihrer Richtung über dem zu erfassenden Weg, so dass deren Position gegenüber einem ortsfesten Sensor entsprechend detektierbar ist. An dem linearen und in einem weiteren Freiheitsgrad beweglichen Bauteil befindet sich mindestens ein Magnet als Bestandteil des Magnetsystems, dem in einem vorgegebenen Abstand mindestens ein gegenüberliegender ortsfester magnetfeldempfindlicher Sensor zugeordnet ist.

In der DE 10 2007 024 867 A1 wird eine Messeinrichtung zur berührungslosen Erfassung eines Drehwinkels beschrieben. Die beschriebene Messeinrichtung umfasst einen ersten Körper, auf dem ein Magnet mit radialem Abstand zu einer Drehachse angeordnet ist, und einen zweiten Körper mit einem magnetfeldempfindlichen Element zur Erzeugung eines Messsignals. Hierbei sind das magnetfeldempfindliche Element und der Magnet bei einer Relativbewegung zwischen dem ersten und zweiten Körper tangential in Bezug zu einer Kreisbahn der Relativbewegung angeordnet, wobei der Magnet in einer zur Drehachse senkrecht zur Radialrichtung angeordneten Ebene radial magnetisiert oder polarisiert ist.

In der DE 10 2008 020 153 A1 wird eine Winkelerfassungsvorrichtung beschrieben. Die beschriebene Vorrichtung umfasst ein Drehelement mit mindestens einem magnetischen Nordpolbereich und mindestens einem magnetischen Südpolbereich, welche abwechselnd um eine Drehmitte angeordnet sind, einen Magnetfelderfassungsabschnitt mit einer Magnetplatte und Erfassungselementen, welche Größen von magnetischen Komponenten in einer zur Magnetplatte senkrechten Richtung erfassen, und eine Recheneinheit, welche einen Drehwinkel des Drehelements bestimmt. Der Magnetfelderfassungsabschnitt ist so angeordnet, dass die Magnetplatte senkrecht zu einer ersten Richtung ausgerichtet ist, in welcher die magnetische Feldstärke maximal ist, wobei der Magnetfelderfassungsabschnitt die Größen der magnetischen Komponenten in der ersten Richtung und in einer zweiten Richtung erfasst, die einer Richtung entspricht, in welcher die magnetischen Nord- und Südpolbereiche umfangsmäßig angeordnet sind.

Aus der JP 2011 226912 A ist eine Sensoreinheit zur Erfassung von Drehwinkeln eines drehbewegten Bauteils mit einem Messwertgeber, welcher mindestens einen Multipol mit mindestens zwei Permanentmagneten mit einem magnetischen Nordpolbereich und einem magnetischen Südpolbereich umfasst und mit einem vorgegebenen radialen ersten Abstand zur Drehachse des drehbewegten Bauteils angeordnet ist, und einem Messwertaufnehmer bekannt, welcher mindestens ein Sensorelement zur Erfassung mindestens einer magnetischen Größe umfasst, welches mit einem vorgegebenen zweiten radialen Abstand zur Drehachse des drehbewegten Bauteils angeordnet ist. Die mindestens zwei Permanentmagnete sind so angeordnet, dass die zugewandten Enden von direkt benachbarten Permanentmagneten des Multipols die gleiche magnetische Polarisierung aufweisen. Eine Bewegung des drehbewegten Bauteils bewirkt eine Veränderung der mindestens einen magnetischen Größe, welche zur Ermittlung des Drehwinkels auswertbar ist, wobei die mindestens zwei Permanentmagnete entlang eines über den ersten radialen Abstand vorgegebenen Kreisbogens um die Drehachse oder tangential dazu polarisiert sind und einen Magnetvektor in einer zur Magnetoberfläche senkrechten Detektionsebene erzeugen. Die Magnetoberflächen sind dem mindestens einen Sensorelement zugewandt und die Detektionsebene umfasst eine Hauptrichtung der mindestens zwei Permanentmagnete.

## Offenbarung der Erfindung

Die erfindungsgemäße Sensoranordnung zur Erfassung von Drehwinkeln an einem drehbewegten Bauteil mit den Merkmalen des unabhängigen Patentanspruchs 1 hat demgegenüber den Vorteil, dass anstatt einer Winkelmessung im Zentrum der Drehbewegung, eine Magnetvektormessung eines auf einer Umlaufbahn bewegten Messwertgebers mit mindestens einem Multipol bzw. Messwertaufnehmers mit mindestens einem Sensorelement durchgeführt wird. Dabei wird nicht mehr der zur Magnetoberfläche parallele Magnetvektor detektiert, sondern der Magnetvektor in der zum Magneten senkrechte Ebene erfasst. Dieser Magnetvektor dreht sich beim Vorbeilaufen des Messwertgebers bzw. Messwertaufnehmers um einen Winkel im Bereich von beispielsweise 150° bis 240° je nach magnetischem Luftspalt zwischen dem Messwertgeber und dem Messwertaufnehmer beim Vorbeilaufen. Ausführungsformen der erfindungsgemäßen Sensoranordnung zur Erfassung von Drehwinkeln an einem drehbeweglichen Bauteil eignen sich insbesondere zur Erfassung von Drehwinkeln in einem Messbereich von 5° bis 95°.

Der Kern der Erfindung liegt in der Überführung einer Winkelmessung in eine Wegmessung auf einer Umlaufbahn mit einem vorgegebenen Radius. Der detektierte Magnetvektor steht somit in einem direkten und definierten Zusammenhang zu dem Weg auf der Kreisbahn und somit auch zum Winkel des überstrichenen Winkelsegments. Die Erfassung des Magnetvektors im Messwertaufnehmer erfolgt direkt durch Sensorelemente, welche diesbezüglich sensitiv sind, wie beispielsweise AMR-Sensoren, oder indirekt über die Auswertung von gerichteten magnetischen Flussdichten in der Detektionsebene mittels einer Arcus-Tangens-Funktion. Durch eine Anpassung des Radius und/oder der Länge des mindestens einen Multipols kann der zu messende Winkelbereich optimal auf den Messbereich des Sensorelementes abgestimmt werden. Die Lage des Messwertaufnehmers zu dem mindestens einen Messwertgeber ist derart angeordnet, dass jeweils immer der Magnetvektor, welcher in einer senkrechten Ebene zum Multipol liegt, erfasst wird, wobei die einzelnen Permanentmagnete des mindestens einen Multipols in Umfangsrichtung magnetisiert bzw. polarisiert sind, und das Sensorelement derart zu dem mindesten einen Multipol ausgerichtet ist, dass diese Magnetvektorkomponente direkt oder indirekt vom Sensorelement erfasst werden kann. Bei indirekt messenden Sensoren, ist die Lage des Sensorelementes so darzustellen, dass die zu erfassende Ebene des Magnetvektors erfasst werden kann. Bei direkt messenden Sensoren ist ebenfalls die korrekte Ausrichtung der sensitiven Ebene des Messelements zu der zu messenden Ebene des Magnetvektors zu berücksichtigen.

Ausführungsformen der vorliegenden Erfindung ermöglichen in vorteilhafter Weise eine optimale Anpassung der erfindungsgemäßen Sensoranordnung an geometrische Gegebenheiten bei optimaler Ausnutzung der Auflösung des vorgegebenen Sensorelements, das beispielsweise als Hallsensor, AMR-Sensor, GMR-Sensor usw. ausgeführt werden kann. Das Sensorelement kann in vorteilhafter Weise hinsichtlich Radius der Umlaufbahn, radialer Abstand zwischen dem Messwertgeber und dem Messwertaufnehmer und/oder die Abmessungen des mindestens einen Multipols und/oder die Anzahl der Multipole und/oder die Abmessungen des mindestens einen Permanentmagneten und/oder die Anzahl der Permanentmagnete des mindestens einen Multipols ausgewählt und dimensioniert werden, so dass eine optimale Auflösung über den Winkelbereich, d.h. eine größtmögliche Änderung der Magnetfeldorientierung über den Messweg bzw. Messwinkel, erreicht werden kann.

Ausführungsformen der vorliegenden Erfindung ermöglichen eine flexible Sensoranordnung zur Erfassung von Drehwinkeln an einem drehbewegten Bauteil, welche in unterschiedlichen Bauräumen unterschiedlicher Applikationen mit unterschiedlichen Messwinkeln bei unveränderten Messwertaufnehmern oder bei Bedarf lediglich durch eine angepasste Programmierung des Messwertaufnehmers eingesetzt werden können.

Ausführungsformen der vorliegenden Erfindung stellen eine Sensoranordnung zur Erfassung von Drehwinkeln an einem drehbewegten Bauteil mit einem Messwertgeber, welcher mindestens einen Permanentmagneten mit einem magnetischen Nordpolbereich und einem magnetischen Südpolbereich umfasst und mit einem vorgegebenen radialen ersten Abstand zur Drehachse des drehbewegten Bauteils angeordnet ist, und einem Messwertaufnehmer zur Verfügung, welcher mindestens ein Sensorelement zur Erfassung mindestens einer magnetischen Größe umfasst, welches mit einem vorgegebenen zweiten radialen Abstand zur Drehachse des drehbewegten Bauteils angeordnet ist. Hierbei bewirkt eine Bewegung des drehbewegten Bauteils eine Veränderung der mindestens einen magnetischen Größe, welche zur Ermittlung des Drehwinkels auswertbar ist, wobei der mindestens eine Permanentmagnet entlang eines über den ersten radialen Abstand vorgegebenen Kreisbogens um die Drehachse oder tangential dazu polarisiert ist und einen Magnetvektor in einer zur Magnetoberfläche senkrechten Detektionsebene erzeugt. Zudem weist der Messwertgeber mindestens einen Multipol auf, welcher mindestens zwei Permanentmagnete umfasst, welche so angeordnet sind, dass die zugewandten Enden von direkt benachbarten Permanentmagneten des Multipols die gleiche magnetische Polarisierung aufweisen. Durch die erfindungsgemäße Anordnung kann bei der Verwendung von zwei Permanentmagneten für den Multipol in vorteilhafter Weise über den gesamten Messbereich des Multipols ein eindeutiges Messsignal erzeugt werden.

Zudem sind die mindestens zwei Permanentmagnete des mindestens einen Multipols des Messwertgebers als Stabmagnete mit einem runden oder rechteckigen Querschnitt und mit einer einseitigen Rundung ausgeführt. Die Rundung kann eine Krümmung aufweisen, welche dem vorgegebenen Kreisbogen der Umlaufbahn des Messwertgebers oder des Messwertaufnehmers entspricht.

Durch die in den abhängigen Ansprüchen aufgeführten Maßnahmen und Weiterbildungen sind vorteilhafte Verbesserungen der im unabhängigen Patentanspruch 1 angegebenen Sensoranordnung zur Erfassung von Drehwinkeln an einem drehbewegten Bauteil möglich.

In vorteilhafter Ausgestaltung der erfindungsgemäßen Sensoranordnung kann das mindestens eine Sensorelement einen Winkel des Magnetvektors direkt detektieren, wobei der erfasste Winkel des Magnetvektors den Drehwinkel des drehbewegten Bauteils repräsentiert. Alternativ kann das mindestens eine Sensorelement gerichtete magnetische Flussdichten detektieren und über eine Arcus-Tangens-Funktion in einen Drehwinkel für das drehbewegten Bauteil umrechnen.

In weiterer vorteilhafter Ausgestaltung der erfindungsgemäßen Sensoranordnung kann der Messwertgeber mit dem drehbewegten Bauteil gekoppelt werden, und der Messwertaufnehmer kann mit einem vorgegebenen radialen Abstand zur Kreisbahn des Messwertgebers ortsfest befestigt werden. Alternativ kann der Messwertaufnehmer mit dem drehbewegten Bauteil gekoppelt werden, und der Messwertgeber kann mit einem vorgegebenen radialen Abstand zur Kreisbahn des Messwertaufnehmers ortsfest befestigt werden.

Besonders vorteilhaft ist, dass der vorgegebene erste und/oder zweite radiale Abstand des Messwertgebers und/oder des Messwertaufnehmers zur Drehachse des drehbewegten Bauteils und/oder der vorgegebene radiale Abstand zwischen dem Messwertgeber und dem Messwertaufnehmer und/oder die Abmessungen des mindestens einen Multipols und/oder die Anzahl der Multipole und/oder die Abmessungen des mindestens einen Permanentmagneten und/oder die Anzahl der Permanentmagnete des mindestens einen Multipols und/oder die Abmessungen des mindestens einen Sensorelements und/oder die Anzahl der Sensorelemente des Messwertaufnehmers an einen Einbauraum und einen Messwinkelbereich angepasst werden können. Vorzugsweise sind die Anordnung des Messwertgebers und/oder des Messwertaufnehmers so an den Einbauraum und den Messwinkelbereich angepasst, dass über den Messwinkelbereich eine maximale Änderung des Winkels des Magnetvektors erfolgt.

In weiterer vorteilhafter Ausgestaltung der erfindungsgemäßen Sensoranordnung kann das mindestens eine Sensorelement des Messwertaufnehmers beispielsweise als AMR-Sensor und/oder GMR-Sensor und/oder Hallsensor ausgeführt werden.

In weiterer vorteilhafter Ausgestaltung der erfindungsgemäßen Sensoranordnung können die mindestens zwei Permanentmagnete des mindestens einen Multipols des Messwertgebers zu einem Tripol mit drei Magnetpolen vereinigt werden, welcher an seinen Enden identische Magnetpole aufweist. Für den Tripol ergibt sich beispielsweise eine Nordpol-Südpol-Nordpol oder eine Südpol-Nordpol-Südpol Reihenfolge der Magnetpole.

Das drehbeweglich Bauteil kann beispielsweise einem Pedal, wie beispielsweise einem Bremspedal oder einem Gaspedal, oder einer Lenksäule entsprechen.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen

Fig. 1 zeigt eine schematische perspektivische Draufsicht auf ein Ausführungsbeispiel einer erfindungsgemäßen Sensoranordnung zur Erfassung von Drehwinkeln an einem drehbewegten Bauteil, welches zur Fahrerbremswunscherkennung eingesetzt wird.

Fig. 2 zeigt eine schematische perspektivische Schnittdarstellung des Ausführungsbeispiels der erfindungsgemäßen Sensoranordnung zur Erfassung von Drehwinkeln an einem drehbewegten Bauteil aus Fig. 1.

Fig. 3 zeigt eine schematische Darstellung von Magnetfeldlinien eines Multipols für die erfindungsgemäße Sensoranordnung zur Erfassung von Drehwinkeln an einem drehbewegten Bauteil aus Fig. 1 oder 2.

Fig. 4 zeigt eine schematische Perspektivdarstellung eines ersten Ausführungsbeispiels eines Multipols für eine aus dem Stand der Technik bekannte Sensoranordnung zur Erfassung von Drehwinkeln an einem drehbewegten Bauteil.

Fig. 5, und 6 zeigen schematische Perspektivdarstellungen von verschiedenen Ausführungsbeispielen von Permanentmagneten zur Bildung von Multipolen für eine aus dem Stand der Technik bekannte Sensoranordnung zur Erfassung von Drehwinkeln an einem drehbewegten Bauteil.

Fig. 7 zeigt eine schematische Perspektivdarstellung eines Ausführungsbeispiels eines Permanentmagneten zur Bildung von Multipolen für die erfindungsgemäße Sensoranordnung zur Erfassung von Drehwinkeln an einem drehbewegten Bauteil aus Fig. 1 oder 2.

Fig. 8 und 9 zeigen schematische Perspektivdarstellungen von verschiedenen Ausführungsbeispielen von Permanentmagneten zur Bildung von Multipolen für eine aus dem Stand der Technik bekannte Sensoranordnung zur Erfassung von Drehwinkeln an einem drehbewegten Bauteil.

Fig. 10 zeigt eine schematische Darstellung eines ersten Anordnungsbeispiels für eine erfindungsgemäße Sensoranordnung zur Erfassung von Drehwinkeln an einem drehbewegten Bauteil mit einem beweglichen Messwertgeber mit einem Multipol, der zwei Permanentmagnete umfasst, und einem feststehenden Messwertaufnehmer.

Fig. 11 zeigt eine schematische Darstellung eines zweiten Anordnungsbeispiels für eine erfindungsgemäße Sensoranordnung zur Erfassung von Drehwinkeln an einem drehbewegten Bauteil mit einem feststehenden Messwertgeber mit einem Multipol, der zwei Permanentmagnete umfasst, und einem beweglichen Messwertaufnehmer.

Fig. 12 zeigt eine schematische Darstellung des Zusammenhangs zwischen Radius, Kreisbahn und Winkelmessbereich der erfindungsgemäßen Sensoranordnung zur Erfassung von Drehwinkeln an einem drehbewegten Bauteil.

Fig. 13 und 14 zeigen mögliche relative Lagen eines feststehenden Messwertaufnehmers zu einem sich auf einer Kreisbahn bewegenden Messwertgeber.

Fig. 15 und 16 zeigen mögliche relative Lagen eines feststehenden Messwertgebers zu einem sich auf einer Kreisbahn bewegenden Messwertaufnehmer.

Fig. 17 zeigt eine schematische Darstellung eines dritten Anordnungsbeispiels für eine erfindungsgemäße Sensoranordnung zur Erfassung von Drehwinkeln an einem drehbewegten Bauteil mit einem beweglichen Messwertgeber mit einem Multipol, der vier Permanentmagnete umfasst, und einem feststehenden Messwertaufnehmer.

Ausführungsformen der Erfindung

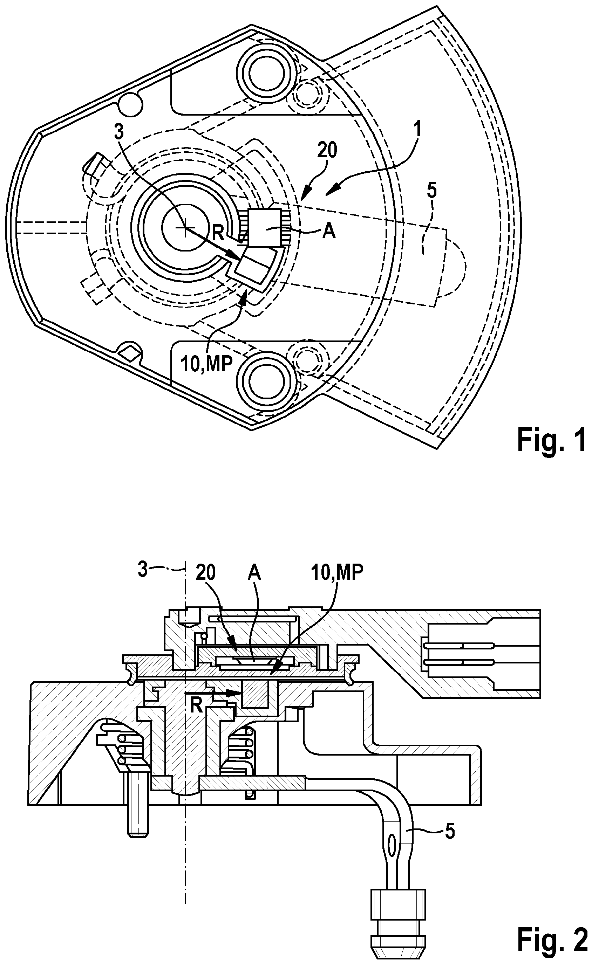

Wie aus Fig. 1 bis 17 ersichtlich ist, umfassen die dargestellten Ausführungsbeispiele einer erfindungsgemäßen Sensoranordnung 1, 1a, 1' zur Erfassung von Drehwinkeln $\alpha$, $\alpha 1$, $\alpha 2$ an einem drehbewegten Bauteil 5 für ein Fahrzeug einen Messwertgeber 10, 10a, welcher mindestens einen Permanentmagneten M1, M2, M3, M4 mit einem magnetischen Nordpolbereich N und einem magnetischen Südpolbereich S umfasst und mit einem vorgegebenen radialen ersten Abstand R, R1, R2, R-I, R+I zur Drehachse 3 des drehbewegten Bauteils 5 angeordnet ist, und einen Messwertaufnehmer 20, welcher mindestens ein Sensorelement A, A', A1, A2 zur Erfassung mindestens einer magnetischen Größe umfasst, welches mit einem vorgegebenen zweiten radialen Abstand R, R-I, R+I zur Drehachse 3 des drehbewegten Bauteils 5 angeordnet ist. Hierbei bewirkt eine Bewegung des drehbewegten Bauteils 5 eine Veränderung der mindestens einen magnetischen Größe, welche zur Ermittlung des Drehwinkels $\alpha$, $\alpha 1$, $\alpha 2$ auswertbar ist, wobei der mindestens eine Permanentmagnet M1, M2, M3, M4 entlang eines über den ersten radialen Abstand R, R1, R2, R-I, R+I vorgegebenen Kreisbogens B, B1, B2 um die Drehachse 3 oder tangential dazu polarisiert ist und einen Magnetvektor in einer zur Magnetoberfläche senkrechten Detektionsebene erzeugt.
Hierbei weist der Messwertgeber 10, 10a mindestens einen Multipol MP, MPa, MP', MP1, MP2 auf, welcher mindestens zwei Permanentmagnete M1, M2, M3, M4 umfasst, welche so angeordnet sind, dass die zugewandten Enden von direkt benachbarten Permanentmagneten M1, M2, M3, M4 des Multipols MP, MPa, MP', MP1, MP2 die gleiche magnetische Polarisierung S, N aufweisen.
Wie aus Fig. 1 bis 4 weiter ersichtlich ist, zeigt das dargestellte Ausführungsbeispiel eine Verwendung der erfindungsgemäßen Sensoranordnung zur Erfassung des Drehwinkels eines drehbewegten Bauteils 5, das mit einem Pedal gekoppelt ist, um einen Fahrerwunsch am Bremspedal oder Gaspedal zu erfassen. Wie aus Fig. 1 und 2 weiter ersichtlich ist, wird eine Welle 3 über einen Hebel 5 von einem nicht dargestellten Pedal verdreht. Mit der Welle 3 ist der Messwertgeber 10 verbunden, welcher einen Multipol MP umfasst, der sich entsprechend der Wellendrehung (z.B. 30°) auf einer Kreisbahn mit einem vorgegebenen radialen Abstand R zur Wellenachse 3 bewegt. Über dem Multipol MP befindet sich in einem definierten Abstand, welcher einen magnetischen Luftspalt repräsentiert, der Messwertaufnehmer 20, welcher vorzugsweise als ASIC (Anwendungsspezifischer integrierter Schaltkreis) mit mindestens einem Sensorelement A ausgeführt ist. Dieses Sensorelement A erfasst den Magnetvektor, welcher sich in der senkrechten Ebene zum Multipol MP während der Drehbewegung ändert. Die Drehung des Multipols MP in dieser Ebene steht in einem definierten Zusammenhang mit dem Weg entlang des Kreissegments B, welches wiederum in einem nach Gleichung (1) definierten Zusammenhang zum Drehwinkel α der Welle 3 steht.

$$B = \frac{\alpha}{360°} * 2\pi * R \qquad\qquad (1)$$

Damit liefert das mindestens eine Sensorelement A ein Signal an eine nachgeschaltete Auswerteschaltung des ASICs, das in den absoluten Drehwinkel, den der Hebel 5 erfährt, überführt werden kann.

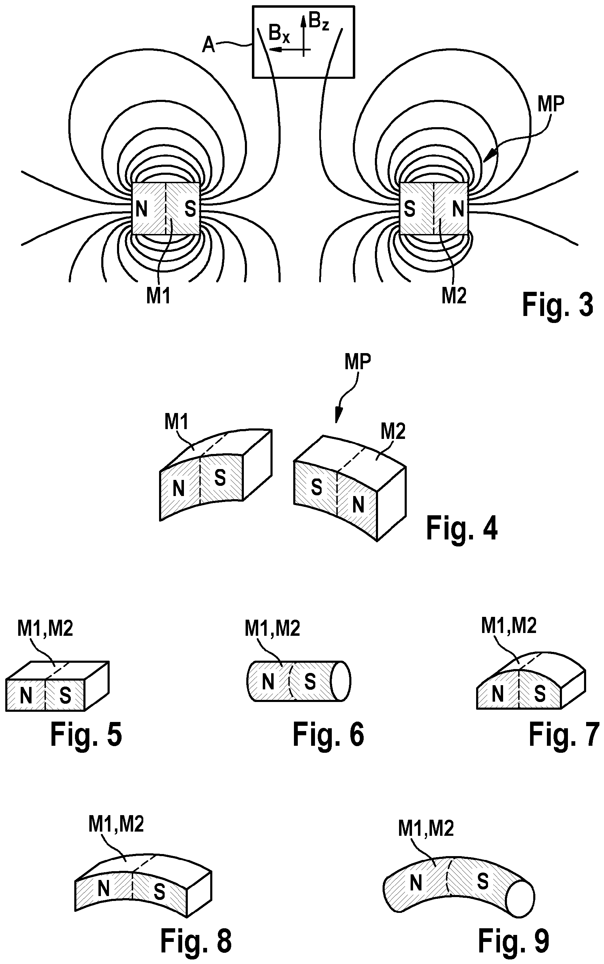

Wie aus Fig. 3 und 4 weiter ersichtlich ist, umfasst der Messwertgeber 10 im dargestellten Ausführungsbeispiel einen Multipol MP mit zwei einzelnen Permanentmagneten M1, M2, welche in Kreisbahnrichtung, also tangential zur Kreisbahn polarisiert sind, wobei die zwei Permanentmagnete M1, M2 so angeordnet sind, dass die zugewandten Enden der benachbarten Permanentmagnete M1, M2 des Multipols MP die gleiche magnetische Polarisierung aufweisen. Im dargestellten Ausführungsbeispiel sind die magnetischen Südpole S der beiden benachbarten Permanentmagnete M1, M2 einander zugewandt. Dadurch erzeugt der Multipol MP in vorteilhafter Weise über den gesamten Messbereich ein eindeutiges Messsignal im mindestens einen Sensorelement A des Messwertaufnehmers 20, so dass ein korrespondierender Drehwinkel der Welle 3 ohne Mehrdeutigkeiten ermittelt werden kann.

Wie aus Fig. 5 bis 9 weiter ersichtlich ist, können die einzelnen Permanentmagnete M1, M2 des Multipols MP verschiedene Ausführungsformen aufweisen. So zeigt Fig. 5 beispielsweise eine herkömmliche Ausführungsform, bei welcher der dargestellte Permanentmagnet M1, M2 als einfacher Stabmagnet mit einem rechteckigen Querschnitt ausgeführt ist. Fig. 6 zeigt eine herkömmliche Ausführungsform, bei welcher der dargestellte Permanentmagnet M1, M2 als einfacher Stabmagnet mit einem runden Querschnitt ausgeführt ist. Fig. 7 zeigt eine erfindungsgemäße Ausführungsform, bei welcher der dargestellte Permanentmagnet M1, M2 als Stabmagnet mit einem rechteckigen Querschnitt und einer einseitigen Rundung ausgeführt ist. Bei einer nicht dargestellten erfindungsgemäßen Ausführungsform ist der Permanentmagnet M1, M2 als Stabmagnet mit einem runden Querschnitt und einer einseitigen Rundung ausgeführt. Fig. 8 zeigt eine herkömmliche Ausführungsform, bei welcher der dargestellte Permanentmagnet M1, M2 als Stabmagnet mit einem rechteckigen Querschnitt und einer doppelseitigen Rundung ausgeführt ist. Fig. 9 zeigt eine herkömmliche Ausführungsform, bei welcher der dargestellte Permanentmagnet M1, M2 als Stabmagnet mit einem runden Querschnitt und einer doppelseitigen Rundung ausgeführt ist. Bei den Ausführungsformen weist die einseitige bzw. doppelseitige Rundung eine Krümmung aufweist, welche dem vorgegebenen Kreisbogen B, B1, B2 der Umlaufbahn des Messwertgebers 10 oder des Messwertaufnehmers 20 entspricht.

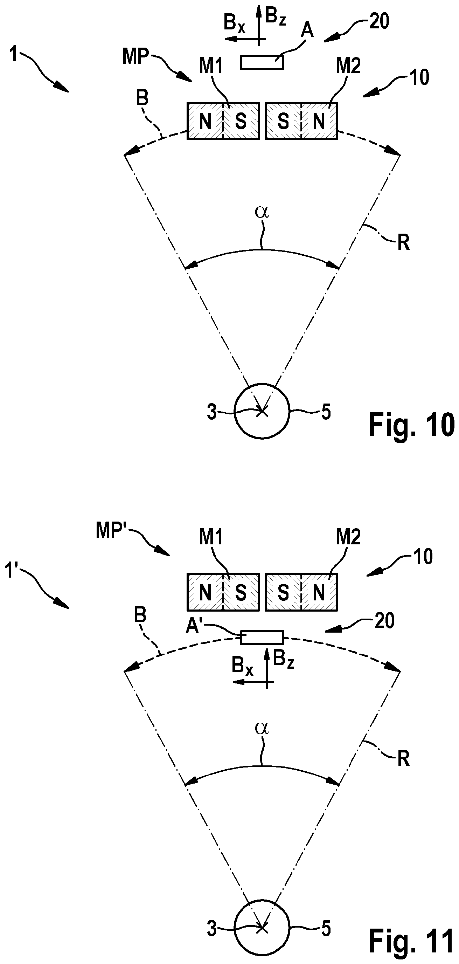

Fig. 10 zeigt ein erstes Anordnungsbeispiel für die erfindungsgemäße Sensoranordnung zur Erfassung von Drehwinkeln α an einem drehbewegten Bauteil 5, bei welchem der Messwertgeber 10 mit dem drehbewegten Bauteil 5 gekoppelt ist und der Messwertaufnehmer 20, welcher mindestens ein Sensorelement A umfasst, ortsfest befestigt ist. Wie oben bereits ausgeführt ist, umfasst der Messwertgeber 10 den Multipol MP mit zwei Permanentmagneten M1, M2, welche sich mit einem radialen Abstand R zur Drehachse 3 auf einer Umlaufbahn befinden und die sich bei einer Drehung relativ zum magnetempfindlichen Sensorelement A des Messwertaufnehmers 20 auf einer Kreisbahn bewegen. Die Permanentmagnete M1, M2 sind in Umfangsrichtung bzw. tangential dazu polarisiert und erzeugen einen Magnetvektor in einer zur Magnetoberfläche senkrechten Ebene, welcher vom Sensorelement A beim Vorbeilaufen erfasst wird, wobei die zwei Permanentmagnete M1, M2 so angeordnet sind, dass die zugewandten Enden der Permanentmagnete M1, M2 die gleiche magnetische Polarisierung aufweisen. Im dargestellten Ausführungsbeispiel sind die magnetischen Südpole S der beiden benachbarten Permanentmagnete M1, M2 einander zugewandt.

Fig. 11 zeigt ein zweites Anordnungsbeispiel für die erfindungsgemäße Sensoranordnung zur Erfassung von Drehwinkeln α an einem drehbewegten Bauteil 5, bei welchem der Messwertaufnehmer 20 mit dem drehbewegten Bauteil 5 gekoppelt ist und der Messwertgeber 10 ortsfest befestigt ist. Der Messwertaufnehmer 20 umfasst mindestens ein Sensorelement A' und befindet sich auf einer Umlaufbahn mit einem radialen Abstand R zur Drehachse 3 und bewegt die sich bei einer Drehung relativ zum Messwertgeber 10 auf einer Kreisbahn. Wie oben bereits ausgeführt ist, umfasst der Messwertgeber 10 den Multipol MP' mit zwei Permanentmagneten M1, M2, welche in Umlaufrichtung des Messwertaufnehmers 20 bzw. tangential dazu polarisiert sind und einen Magnetvektor in einer zur Magnetoberfläche senkrechten Ebene erzeugen, welcher vom Sensorelement A beim Vorbeilaufen erfasst wird. Analog zu Fig. 10 sind die zwei Permanentmagnete M1, M2 so angeordnet, dass die zugewandten Enden der Permanentmagnete M1, M2 die gleiche magnetische Polarisierung aufweisen. Im dargestellten Ausführungsbeispiel sind die magnetischen Südpole S der beiden benachbarten Permanentmagnete M1, M2 einander zugewandt.

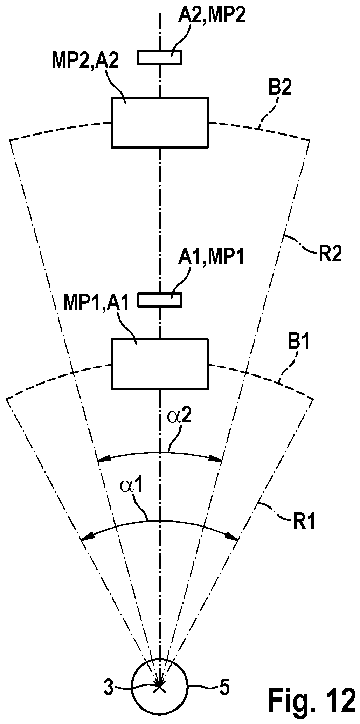

Wie aus Fig. 12 weiter ersichtlich ist, besteht zwischen dem radialen Abstand R1, R2 der auf einer Kreisbahn B1, B2 umlaufenden Komponenten MP1 bzw. A1 oder MP2, A2, und dem Winkelmessbereich der erfindungsgemäßen Sensoranordnung zur Erfassung von Drehwinkeln $\alpha 1$, $\alpha 2$ an einem drehbewegten Bauteil 5 der Zusammenhang B1=B2=Konstant. Daraus ergibt sich Gleichung (2).

$$R_1 * \alpha_1 = R_2 * \alpha_2 \qquad\qquad (2)$$

Der detektierte Magnetvektor steht in einem direkten und definierten Zusammenhang zu dem Weg B1, B2 auf der Kreisbahn und somit auch zum Winkel $\alpha 1$, $\alpha 2$ des überstrichenen Winkelsegments. Bei den dargestellten Ausführungsbeispielen detektiert das mindestens eine Sensorelement A, A', A1, A2 des Messwertaufnehmers 20 gerichtete magnetische Flussdichten Bx, Bz, welche die Auswerteschaltung des Messwertaufnehmers 20 in einen Drehwinkel $\alpha$, $\alpha 1$, $\alpha 2$ für das drehbewegten Bauteil 5 umrechnet. Alternativ kann das mindestens eine Sensorelement A direkt einen Winkel des Magnetvektors detektieren, wobei der erfasste Winkel des Magnetvektors den Drehwinkel $\alpha$, $\alpha 1$, $\alpha 2$ des drehbewegten Bauteils 5 repräsentiert. Durch Anpassung des radialen Abstands R, R1, R2 zur Drehachse 3 und/oder der Abmessungen des Multipols MP, MP', MP1, MP2 bzw. der Permanentmagnete M1, M2 des Multipols MP, MP' kann der zu messende Winkelbereich optimal auf den Messbereich des mindestens einen Sensorelements A, A', A1, A2 abgestimmt werden. Dies gilt sowohl für das erste Anordnungsbeispiel der erfindungsgemäßen Sensoranordnung zur Erfassung von Drehwinkeln an einem drehbewegten Bauteil aus Fig. 10, als auch für das zweite Anordnungsbeispiel der erfindungsgemäßen Sensoranordnung zur Erfassung von Drehwinkeln an einem drehbewegten Bauteil aus Fig. 11. Das mindestens eine Sensorelement A, A', A1, A2 des Messwertaufnehmers 20 ist beispielsweise als AMR-Sensor und/oder GMR-Sensor und/oder Hallsensor ausgeführt.

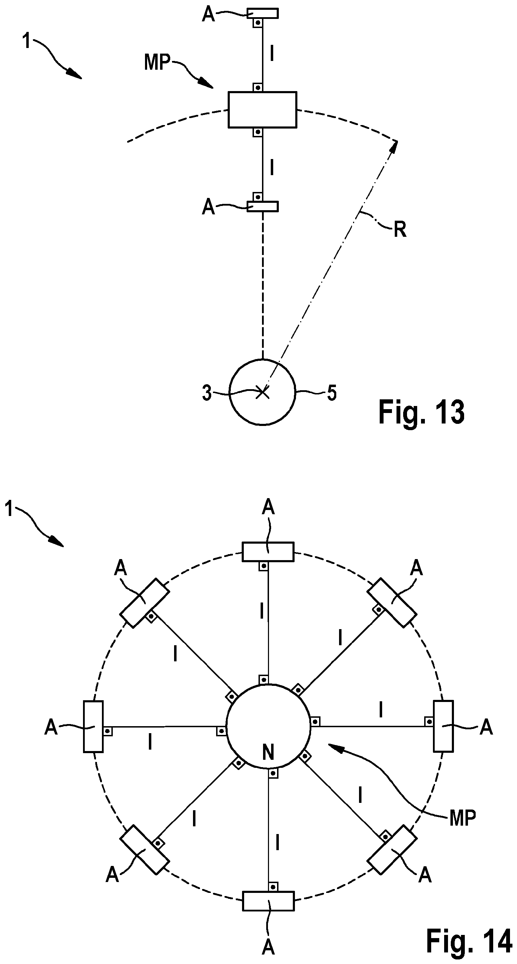

Fig. 13 und 14 zeigen mögliche relative Lagen eines feststehenden Sensorelements A des Messwertaufnehmers 20 zu einem sich mit dem Abstand R auf einer Kreisbahn bewegenden Multipol MP des Messwertgebers 10.

Wie aus Fig. 13 weiter ersichtlich ist, ist das mindestens eine Sensorelement A des Messwertaufnehmer 20 mit einem vorgegebenen radialen Abstand I zur Kreisbahn des Multipols MP des Messwertgeber 10 ortsfest befestigt. Hierbei kann das mindestens eine Sensorelement A einen radialen Abstand von (R-I) zur Drehachse 3 aufweisen. Alternativ kann das mindestens eine Sensorelement A einen radialen Abstand von (R+I) zur Drehachse 3 aufweisen. Wie aus Fig. 14 weiter ersichtlich ist, kann das mindestens eine Sensorelements A verschiedenen Positionen auf einem Umkreis mit dem Radius I um den Multipol MP des Messwertgebers 10 einnehmen. Die Lage des mindestens einen Sensorelements A zum Multipol MP ist derart gewählt, dass immer der Magnetvektor erfasst wird, der in der senkrechten Ebene zum Multipol MP liegt, wobei die Permanentmagnete M1, M2 des Multipols MP in Umfangsrichtung magnetisiert bzw. polarisiert sind.

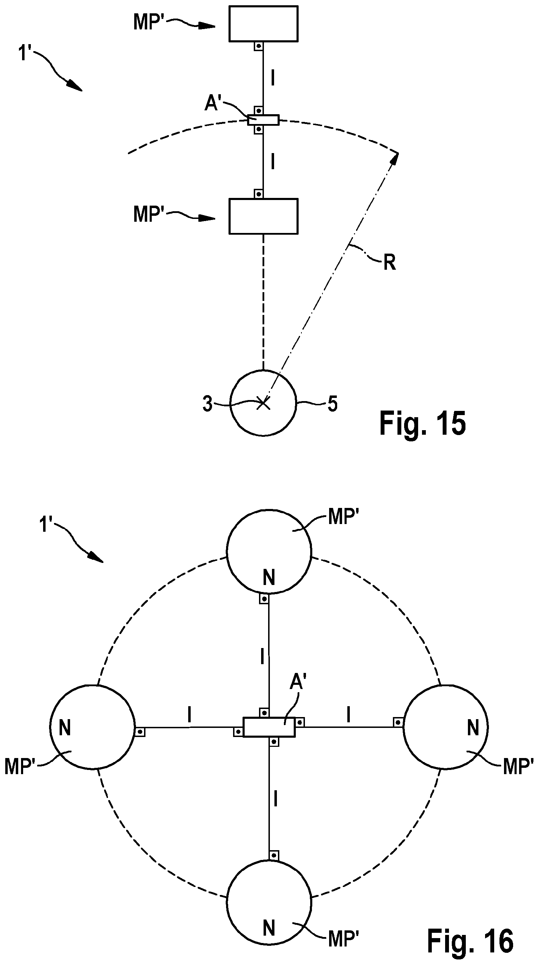

Fig. 15 und 16 zeigen mögliche relative Lagen eines feststehenden Messwertgebers 10 mit einem Multipol MP' zu einem sich mit dem Abstand R auf einer Kreisbahn bewegenden Messwertaufnehmer mit mindestens einem Sensorelement A'.

Wie aus Fig. 15 weiter ersichtlich ist, ist der Multipol MP' des Messwertgebers 10 mit einem vorgegebenen radialen Abstand I zur Kreisbahn des mindestens einen Sensorelements A' des Messwertaufnehmer 20 ortsfest befestigt. Hierbei kann der Multipol MP' des Messwertgebers 10 einen radialen Abstand von (R-I) zur Drehachse 3 aufweisen. Alternativ kann der Multipol MP' des Messwertgebers 10 einen radialen Abstand von (R+I) zur Drehachse 3 aufweisen. Wie aus Fig. 16 weiter ersichtlich ist, kann der Multipol MP' des Messwertgebers 10 verschiedene Positionen auf einem Umkreis mit dem Radius I um das mindestens eine Sensorelement A' des Messwertaufnehmers 20 einnehmen. Die Lage des Multipols MP' zum mindestens einen Sensorelement A' ist derart gewählt, dass immer der Magnetvektor erfasst wird, der in der senkrechten Ebene zum Multipol MP' liegt, wobei die Permanentmagnete M1, M2 des Multipols MP' in Umfangsrichtung der Kreisbewegung des mindestens einen Sensorelements A' magnetisiert bzw. polarisiert sind.

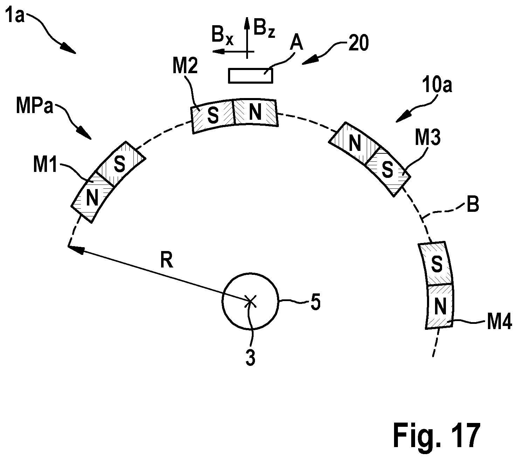

Fig. 17 zeigt ein drittes Anordnungsbeispiel für die erfindungsgemäße Sensoranordnung 1a zur Erfassung von Drehwinkeln an einem drehbewegten Bauteil 5, bei welchem der Messwertgeber 10a mit dem drehbewegten Bauteil 5 gekoppelt ist und der Messwertaufnehmer 20, welcher mindestens ein Sensorelement A umfasst, ortsfest befestigt ist. Im dargestellten Ausführungsbeispiel umfasst der Messwertgeber 10a einen Multipol MPa mit vier Permanentmagneten M1, M2, M3, M4, welche sich mit einem radialen Abstand R zur Drehachse 3 auf einer Umlaufbahn befinden und die sich bei einer Drehung relativ zum magnetempfindlichen Sensorelement A des Messwertaufnehmers 20 auf einer Kreisbahn bewegen. Die Permanentmagnete M1, M2, M3, M4 sind in Umfangsrichtung bzw. tangential dazu polarisiert und erzeugen einen Magnetvektor in einer zur Magnetoberfläche senkrechten Ebene, welcher vom Sensorelement A beim Vorbeilaufen erfasst wird, wobei die vier Permanentmagnete M1, M2, M3, M4 so angeordnet sind, dass die zugewandten Enden der Permanentmagnete M1, M2, M3, M4 die gleiche magnetische Polarisierung aufweisen. Im dargestellten Ausführungsbeispiel sind die magnetischen Südpole S der benachbarten ersten und zweiten Permanentmagnete M1, M2 und der benachbarten dritten und vierten Permanentmagnete M3, M4 einander zugewandt. Bei den benachbarten zweiten und dritten Permanentmagnete M2, M3 sind die magnetischen Nordpole N einander zugewandt. Bei der Verwendung eines Multipols mit vier Permanentmagneten und acht Magnetpolen ergibt sich bei der erfindungsgemäßen Anordnung eine Wiederholung der Messsignale innerhalb des Messbereichs, so dass allein die Messsignale kein eindeutiges Messergebnis liefern, so dass bei der Auswertung zur Auflösung der Mehrdeutigkeit zusätzliche Maßnahmen ergriffen werden.

Selbstverständlich ist die Anzahl der Permanentmagnete bzw. die Anzahl der Magnetpole des verwendeten Multipols nicht auf zwei oder vier Permanentmagnete mit vier bzw. acht Magnetpolen begrenzt, so dass auch eine andere Anzahl von Permanentmagneten bzw. Magnetpolen verwendet werden kann.

Bei einem nicht dargestellten Ausführungsbeispiel der erfindungsgemäßen Sensoranordnung werden beispielsweise die mindestens zwei Permanentmagnete des mindestens einen Multipols des Messwertgebers zu einem Tripol mit drei Magnetpolen vereinigt, welcher an seinen Enden identische Magnetpole aufweist. Für einen solchen Tripol ergibt sich beispielsweise eine Nordpol-Südpol-Nordpol oder eine Südpol-Nordpol-Südpol Reihenfolge der Magnetpole.

Zur Anpassung an einen Einbauraum und einen Messwinkelbereich können der vorgegebene erste und/oder zweite radiale Abstand R, R1, R2, R-I, R+I des Messwertgebers 10, 10a und/oder des Messwertaufnehmers 20 zur Drehachse 3 des drehbewegten Bauteils 5 und/oder der vorgegebene radiale Abstand I zwischen dem Messwertgeber 10, 10a und dem Messwertaufnehmer 20 und/oder die Abmessungen des mindestens einen Multipols MP, MPa, MP', MP1, MP2 und/oder die Anzahl der Multipole MP, MPa, MP', MP1, MP2 und/oder die Abmessungen des mindestens einen Permanentmagneten M1, M2, M3, M4 und/oder die Anzahl der Permanentmagnete M1, M2, M3, M4 des mindestens einen Multipols MP, MPa, MP', MP1, MP2 und/oder die Abmessungen des mindestens einen Sensorelements A, A', A1, A2 und/oder die Anzahl der Sensorelemente A, A', A1, A2 des Messwertaufnehmers 20 entsprechend gewählt und ausgeführt werden. Des Weiteren sind die Anordnung des Messwertgebers 10, 10a und/oder des Messwertaufnehmers 20 so an den Einbauraum und den Messwinkelbereich angepasst, dass über den Messwinkelbereich eine maximale Änderung des Winkels des Magnetvektors erfolgt.

Alternativ zur Ermittlung einer Pedalstellung, können Ausführungsformen der erfindungsgemäßen Sensoranordnung auch zur Ermittlung eines Drehwinkels einer Lenksäule oder anderer im Fahrzeug vorhandener drehbarer Bauteile eingesetzt werden.

## Patentansprüche

1. Sensoranordnung zur Erfassung von Drehwinkeln eines drehbewegten Bauteils mit einem Messwertgeber (10, 10a), welcher mindestens einen Multipol (MP, MPa, MP', MP1, MP2) mit mindestens zwei Permanentmagneten (M1, M2, M3, M4) mit einem magnetischen Nordpolbereich (N) und einem magnetischen Südpolbereich (S) umfasst und mit einem vorgegebenen radialen ersten Abstand (R, R1, R2, R-I, R+I) zur Drehachse (3) des drehbewegten Bauteils (5) angeordnet ist, und einem Messwertaufnehmer (20), welcher mindestens ein Sensorelement (A, A', A1, A2) zur Erfassung mindestens einer magnetischen Größe umfasst, welches mit einem vorgegebenen zweiten radialen Abstand (R, R-I, R+I) zur Drehachse (3) des drehbewegten Bauteils (5) angeordnet ist, wobei die mindestens zwei Permanentmagnete (M1, M2, M3, M4) so angeordnet sind, dass die zugewandten Enden von direkt benachbarten Permanentmagneten (M1, M2, M3, M4) des Multipols (MP, MPa, MP', MP1, MP2) die gleiche magnetische Polarisierung (S, N) aufweisen, wobei eine Bewegung des drehbewegten Bauteils (5) eine Veränderung der mindestens einen magnetischen Größe bewirkt, welche zur Ermittlung des Drehwinkels ($\alpha$, $\alpha1$, $\alpha2$) auswertbar ist, wobei die mindestens zwei Permanentmagnete (M1, M2, M3, M4) entlang eines über den ersten radialen Abstand (R, R1, R2, R-I, R+I) vorgegebenen Kreisbogens (B, B1, B2) um die Drehachse (3) oder tangential dazu polarisiert sind und einen Magnetvektor in einer zur Magnetoberfläche senkrechten Detektionsebene erzeugen, wobei die Magnetoberflächen dem mindestens einen Sensorelement (A, A', A1, A2) zugewandt sind und die Detektionsebene eine Hauptrichtung der mindestens zwei Permanentmagnete (M1, M2, M3, M4) umfasst, **dadurch gekennzeichnet, dass** die mindestens zwei Permanentmagnete (M1, M2, M3, M4) des mindestens einen Multipols (MP, MPa, MP', MP1, MP2) des Messwertgebers (10, 10a) als Stabmagnete mit einem runden oder rechteckigen Querschnitt und mit einer einseitigen Rundung ausgeführt sind.

2. Sensoranordnung nach Anspruch 1, **dadurch gekennzeichnet, dass** das mindestens eine Sensorelement (A) direkt einen Winkel des Magnetvektors detektiert, wobei der erfasste Winkel des Magnetvektors den Drehwinkel ($\alpha$, $\alpha1$, $\alpha2$) des drehbewegten Bauteils (5) repräsentiert.

3. Sensoranordnung nach Anspruch 1, **dadurch gekennzeichnet, dass** das mindestens eine Sensorelement (A, A', A1, A2) gerichtete magnetische Flussdichten ($B_x$, $B_z$) detektiert und in einen Drehwinkel ($\alpha$, $\alpha1$, $\alpha2$) für das dreh-bewegte Bauteil (5) umrechnet.

4.  Sensoranordnung nach einem der Ansprüche 1 bis 3, **dadurch gekennzeichnet, dass** der Messwertgeber (10, 10a) mit dem drehbewegten Bauteil (5) gekoppelt ist und der Messwertaufnehmer (20) mit einem vorgegebenen radialen Abstand (I) zur Kreisbahn des Messwertgebers (10, 10a) befestigt ist.

5.  Sensoranordnung nach einem der Ansprüche 1 bis 3, **dadurch gekennzeichnet, dass** der Messwertaufnehmer (20) mit dem drehbewegten Bauteil (5) gekoppelt ist und der Messwertgeber (10) mit einem vorgegebenen radialen Abstand (I) zur Kreisbahn des Messwertaufnehmers (20) befestigt ist.

6.  Sensoranordnung nach einem der Ansprüche 1 bis 5, **dadurch gekennzeichnet, dass** der vorgegebene erste und/oder zweite radiale Abstand (R, R1, R2, R-I, R+I) des Messwertgebers (10, 10a) und/oder des Messwertaufnehmers (20) zur Drehachse (3) des drehbewegten Bauteils (5) und/oder der vorgegebene radiale Abstand (I) zwischen dem Messwertgeber (10, 10a) und dem Messwertaufnehmer (20) und/oder die Abmessungen des mindestens einen Multipols (MP, MPa, MP', MP1, MP2) und/oder die Anzahl der Multipole (MP, MPa, MP', MP1, MP2) und/oder die Abmessungen des mindestens einen Permanentmagneten (M1, M2, M3, M4) und/oder die Anzahl der Permanentmagnete (M1, M2, M3, M4) des mindestens einen Multipols (MP, MPa, MP', MP1, MP2) und/oder die Abmessungen des mindestens einen Sensorelements (A, A', A1, A2) und/oder die Anzahl der Sensorelemente (A, A', A1, A2) des Messwertaufnehmers (20) an einen Einbauraum und einen Messwinkelbereich angepasst sind.

7.  Sensoranordnung nach Anspruch 6, **dadurch gekennzeichnet, dass** die Anordnung des Messwertgebers (10, 10a) und/oder des Messwertaufnehmers (20) so an einen Einbauraum und einen Messwinkelbereich angepasst sind, dass über den Messwinkelbereich eine maximale Änderung des Winkels des Magnetvektors erfolgt.

8.  Sensoranordnung nach einem der Ansprüche 1 bis 7, **dadurch gekennzeichnet, dass** das mindestens eine Sensorelement (A, A', A1, A2) des Messwertaufnehmers (20) als AMR-Sensor und/oder GMR-Sensor und/oder Hallsensor ausgeführt ist.

9.  Sensoranordnung nach einem der Ansprüche 1 bis 8, **dadurch gekennzeichnet, dass** die Rundung eine Krümmung aufweist, welche dem vorgegebenen Kreisbogen (B, B1, B2) der Umlaufbahn des Messwertgebers (10, 10a) oder des Messwertaufnehmers (20) entspricht.

10. Sensoranordnung nach einem der Ansprüche 1 bis 9, **dadurch gekennzeichnet, dass** die mindestens zwei Permanentmagnete (M1, M2, M3, M4) des mindestens einen Multipols (MP, MPa, MP', MP1, MP2) des Messwertgebers (10, 10a) zu einem Tripol mit drei Magnetpolen (S, N) vereinigt sind, welcher an seinen Enden identische Magnetpole aufweist (S, N).

11. Sensoranordnung nach einem der Ansprüche 1 bis 10, **dadurch gekennzeichnet, dass** das drehbewegliche Bauteil (5) einem Pedal oder einer Lenksäule entspricht.

**Claims**

1.  Sensor arrangement for detecting angles of rotation of a rotated component, having a measured value transmitter (10, 10a) which comprises at least one multipole (MP, MPa, MP', MP1, MP2) having at least two permanent magnets (M1, M2, M3, M4) with a magnetic north pole region (N) and a magnetic south pole region (S), and which is arranged with a prescribed radial first distance (R, R1, R2, R-1, R+1) from the rotational axis (3) of the rotated component (5), and a measured value sensor (20) which, for the purpose of detecting at least one magnetic variable, comprises at least one sensor element (A, A', A1, A2) which is arranged with a prescribed second radial distance (R, R-1, R+1) from the rotational axis (3) of the rotated component (5), the at least two permanent magnets (M1, M2, M3, M4) being arranged such that the mutually facing ends of directly adjacent permanent magnets (M1, M2, M3, M4) of the multipole (MP, MPa, MP', MP1, MP2) have the same magnetic polarization (S, N), a movement of the rotated component (5) effecting a variation in the at least one magnetic variable which can be evaluated in order to determine the angle of rotation ($\alpha$, $\alpha1$, $\alpha2$), the at least two permanent magnets (M1, M2, M3, M4) being polarized along a circular arc (B, B1, B2), prescribed via the first radial distance (R, R1, R2, R-1, R+1), about the rotational axis (3) or tangential thereto, and generating a magnetic vector in a detection plane perpendicular to the magnet surface, the magnet surfaces facing the at least one sensor element (A, A', A1, A2) and the detection plane comprising a main direction of the at least two permanent magnets (M1, M2, M3, M4), **characterized in that** the at least two permanent magnets (M1, M2, M3, M4) of the at least one multipole (MP, MPa, MP', MP1, MP2) of the measured value transmitter (10, 10a) are designed as bar magnets with a round or rectangular cross section and with a single-ended rounded portion.

2. Sensor arrangement according to Claim 1, **characterized in that** the at least one sensor element (A) directly detects an angle of the magnetic vector, the detected angle of the magnetic vector representing the angle of rotation ($\alpha$, $\alpha1$, $\alpha2$) of the rotated component (5).

3. Sensor arrangement according to Claim 1, **characterized in that** the at least one sensor element (A, A', A1, A2) detects directed magnetic flux densities (Bx, Bz) and converts them into an angle of rotation ($\alpha$, $\alpha1$, $\alpha2$) for the rotated component (5).

4. Sensor arrangement according to one of Claims 1 to 3, **characterized in that** the measured value transmitter (10, 10a) is coupled to the rotated component (5), and the measured value sensor (20) is fastened with a prescribed radial distance (1) from the circular track of the measured value transmitter (10, 10a).

5. Sensor arrangement according to one of Claims 1 to 3, **characterized in that** the measured value sensor (20) is coupled to the rotated component (5), and the measured value transmitter (10) is fastened with a prescribed radial distance (1) from the circular track of the measured value sensor (20).

6. Sensor arrangement according to one of Claims 1 to 5, **characterized in that** the prescribed first and/or second radial distance (R, R1, R2, R-1, R+1) of the measured value transmitter (10, 10a) and/or of the measured value sensor (20) from the rotational axis (3) of the rotated component (5), and/or the prescribed radial distance (1) between the measured value transmitter (10, 10a) and the measured value sensor (20), and/or the dimensions of the at least one multipole (MP, MPa, MP', MP1, MP2), and/or the number of the multipoles (MP, MPa, MP', MP1, MP2), and/or the dimensions of the at least one permanent magnet (M1, M2, M3, M4), and/or the number of the permanent magnets (M1, M2, M3, M4) of the at least one multipole (MP, MPa, MP', MP1, MP2), and/or the dimensions of the at least one sensor element (A, A', A1, A2), and/or the number of the sensor elements (A, A', A1, A2) of the measured value sensor (20) are adapted to an installation space and a measured angle range.

7. Sensor arrangement according to Claim 6, **characterized in that** the arrangement of the measured value transmitter (10, 10a) and/or of the measured value sensor (20) are adapted to an installation space and a measured angle range such that a maximum change in the angle of the magnetic vector occurs over the measured angle range.

8. Sensor arrangement according to one of Claims 1 to 7, **characterized in that** the at least one sensor element (A, A', A1, A2) of the measured value sensor (20) is designed as an AMR sensor and/or GMR sensor and/or Hall sensor.

9. Sensor arrangement according to one of Claims 1 to 8, **characterized in that** the rounded portion has a curvature which corresponds to the prescribed circular arc (B, B1, B2) of the rotational path of the measured value transmitter (10, 10a) or of the measured value sensor (20).

10. Sensor arrangement according to one of Claims 1 to 9, **characterized in that** the at least two permanent magnets (M1, M2, M3, M4) of the at least one multipole (MP, MPa, MP', MP1, MP2) of the measured value transmitter (10, 10a) are combined to form a tripole with three magnetic poles (S, N) which has identical magnetic poles at its ends (S, N).

11. Sensor arrangement according to one of Claims 1 to 10, **characterized in that** the rotating component (5) corresponds to a pedal or a steering column.

## Revendications

1. Arrangement capteur destiné à détecter des angles de rotation d'un élément structural en mouvement rotatif, comprenant un transmetteur de valeur mesurée (10, 10a) qui comporte au moins un multipôle (MP, MPa, MP', MP1, MP2) ayant au moins deux aimants permanents (M1, M2, M3, M4) avec une zone de pôle nord magnétique (N) et une zone de pôle sud magnétique (S) et qui est disposé avec un premier écart radial (R, R1, R2, R-I, R+I) prédéfini par rapport à l'axe de rotation (3) de l'élément structural (5) en mouvement rotatif, et un enregistreur de valeur mesurée (20) qui comporte au moins un élément capteur (A, A', A1, A2) destiné à détecter au moins une grandeur magnétique, lequel est disposé avec un deuxième écart radial (R, R-I, R+I) prédéfini par rapport à l'axe de rotation (3) de l'élément structural (5) en mouvement rotatif, les au moins deux aimants permanents (M1, M2, M3, M4) étant disposés de telle sorte que les extrémités se faisant face des aimants permanents (M1, M2, M3, M4) directement voisins du multipôle (MP, MPa, MP', MP1, MP2) présentent la même polarisation magnétique (S, N), un mouvement de l'élément structural (5) en mouvement rotatif provoquant une modification de l'au moins une grandeur magnétique, laquelle peut être interprétée pour déterminer l'angle de rotation ($\alpha$, $\alpha1$, $\alpha2$), les au moins deux aimants permanents (M1, M2, M3, M4) étant polarisés le long d'un arc de cercle (B, B1, B2) prédéfini par le premier écart radial (R, R1, R2, R-I, R+I) autour de l'axe de rotation (3) ou tangentiellement à celui-ci et générant un vecteur magnétique dans un plan de détection perpendiculaire à la surface des aimants, les surfaces d'aimant faisant face à l'au moins un élément capteur (A, A', A1, A2) et le plan de détection comprenant une direction principale des au moins deux aimants permanents (M1, M2, M3, M4), **caractérisé en ce que** les au moins deux aimants permanents (M1, M2, M3, M4) de l'au moins un multipôle (MP, MPa, MP', MP1, MP2) du transmetteur de valeur mesurée (10, 10a) sont réalisés sous la forme de barreaux aimantés ayant une section transversale ronde ou rectangulaire et munis d'un arrondi unilatéral.

2. Arrangement capteur selon la revendication 1, **caractérisé en ce que** l'au moins un élément capteur (A) détecte directement un angle du vecteur magnétique, l'angle détecté du vecteur magnétique représentant l'angle de rotation ($\alpha$, $\alpha1$, $\alpha2$) de l'élément structural (5) en mouvement rotatif.

3. Arrangement capteur selon la revendication 1, **caractérisé en ce que** l'au moins un élément capteur (A, A', A1, A2) détecte des densités de flux magnétique ($B_x$, $B_z$) dirigées et les convertit en un angle de rotation ($\alpha$, $\alpha1$, $\alpha2$) pour l'élément structural (5) en mouvement rotatif.

4. Arrangement capteur selon l'une des revendications 1 à 3, **caractérisé en ce que** le transmetteur de valeur mesurée (10, 10a) est couplé à l'élément structural (5) en mouvement rotatif et l'enregistreur de valeur mesurée (20) est fixé avec un écart radial (I) prédéfini par rapport à la trajectoire circulaire du transmetteur de valeur mesurée (10, 10a).

5. Arrangement capteur selon l'une des revendications 1 à 3, **caractérisé en ce que** l'enregistreur de valeur mesurée (20) est couplé à l'élément structural (5) en mouvement rotatif et le transmetteur de valeur mesurée (10) est fixé avec un écart radial (I) prédéfini par rapport à la trajectoire circulaire de l'enregistreur de valeur mesurée (20).

6. Arrangement capteur selon l'une des revendications 1 à 5, **caractérisé en ce que** le premier et/ou le deuxième écart radial (R, R1, R2, R-I, R+I) prédéfini du transmetteur de valeur mesurée (10, 10a) et/ou de l'enregistreur de valeur mesurée (20) par rapport à l'axe de rotation (3) de l'élément structural (5) en mouvement rotatif et/ou l'écart radial (I) prédéfini entre le transmetteur de valeur mesurée (10, 10a) et l'enregistreur de valeur mesurée (20) et/ou les dimensions de l'au moins un multipôle (MP, MPa, MP', MP1, MP2) et/ou le nombre de multipôles (MP, MPa, MP', MP1, MP2) et/ou les dimensions de l'au moins un aimant permanent (M1, M2, M3, M4) et/ou le nombre d'aimants permanents (M1, M2, M3, M4) de l'au moins un multipôle (MP, MPa, MP', MP1, MP2) et/ou les dimensions de l'au moins un élément capteur (A, A', A1, A2) et/ou le nombre d'éléments capteurs (A, A', A1, A2) de l'enregistreur de valeur mesurée (20) sont adaptés à un espace de montage et une plage d'angles de mesure.

7. Arrangement capteur selon la revendication 6, **caractérisé en ce que** l'arrangement du transmetteur de valeur mesurée (10, 10a) et/ou de l'enregistreur de valeur mesurée (20) est adapté à un espace de montage et une plage d'angles de mesure de telle sorte qu'une modification maximale de l'angle du vecteur magnétique a lieu sur la plage d'angles de mesure.

8. Arrangement capteur selon l'une des revendications 1 à 7, **caractérisé en ce que** l'au moins un élément capteur (A, A', A1, A2) de l'enregistreur de valeur mesurée (20) est réalisé sous la forme d'un capteur AMR et/ou d'un capteur GMR et/ou d'un capteur à effet Hall.

9. Arrangement capteur selon l'une des revendications 1 à 8, **caractérisé en ce que** l'arrondi présente une courbure qui correspond à l'arc de cercle (B, B1, B2) prédéfini de la trajectoire circulaire du transmetteur de valeur mesurée (10, 10a) ou de l'enregistreur de valeur mesurée (20).

10. Arrangement capteur selon l'une des revendications 1 à 9, **caractérisé en ce que** les au moins deux aimants permanents (M1, M2, M3, M4) de l'au moins un multipôle (MP, MPa, MP', MP1, MP2) du transmetteur de valeur mesurée (10, 10a) sont réunis en un tripôle ayant trois pôles magnétiques (S, N) qui présente des pôles magnétiques identiques (S, N) à ses extrémités.

11. Arrangement capteur selon l'une des revendications 1 à 10, **caractérisé en ce que** l'élément structural (5) à mobilité de rotation correspond à une pédale ou à une colonne de direction.

Fig. 1

Fig. 2

EP 2 888 559 B1

Fig. 3

Fig. 4

Fig. 5

Fig. 6

Fig. 7

Fig. 8

Fig. 9

14

Fig. 10

Fig. 11

Fig. 12

1

MP

A

I

MP

I

A

R

3 ⊗ 5

# Fig. 13

1

A

A

A

A

I

I

I

I

I

N

I

I

I

A

A

MP

A

A

# Fig. 14

MP' →

1'

I

A'

I

MP' →

R

3 ⊗ 5

# Fig. 15

1'

MP'

N

I

A'

N I I N

MP' MP'

I

N

MP'

# Fig. 16

Fig. 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009055104 A1
- DE 102007024867 A1
- DE 102008020153 A1
- JP 2011226912 A